# EUROPÄISCHE PATENTSCHRIFT

(11) **EP 0 775 758 B1**
(45) Veröffentlichungstag und Bekanntmachung des Hinweises auf die Patenterteilung: **26.08.1998**
(21) Anmeldenummer: 96117215.2
(22) Anmeldetag: 26.10.1996
(51) Int. Cl.: C23C 14/24, C23C 14/56, C23C 14/02, C23C 14/35

(54) **Vakuumbeschichtungsanlage mit einem in der Vakuumkammer angeordneten Tiegel zur Aufnahme von zu verdampfendem Material**
Vacuum coating apparatus with a crucible located in the vacuum chamber to receive the evaporation material
Appareillage de revêtement sous vide avec un creuset pour recevoir le matériau à évaporer dans la chambre à vide

(30) Priorität: 24.11.1995 DE 19543781
(43) Veröffentlichungstag der Anmeldung: 28.05.1997
(73) Patentinhaber: Balzers und Leybold Deutschland Holding AG, 63450 Hanau (DE)
(72) Erfinder: Szczyrbowski, Joachim, Dr., 63773 Goldbach (DE); Teschner, Götz, 63450 Hanau (DE); Steiniger, Gerhard, 63549 Ronneburg (DE)

(56) Entgegenhaltungen:
- EP-A- 0 570 618
- DE-C- 4 343 042

## Beschreibung

Die Erfindung betrifft eine Vakuumbeschichtungsanlage mit einem in einer Vakuumkammer angeordneten Tiegel zur Aufnahme des zu verdampfenden Materials, beispielsweise eines Metalls oder Metalloxids oder einer Mischung aus beidem, und mit einem in einem Abstand vom zu verdampfenden Material über Walzen geführten Folienband.

Bekannt ist eine Vakuumbeschichtungsanlage (DE-A-42 03 632) mit einem Behälter, in dem sich ein zu verdampfendes Material befindet, mit einer Verdampfervorrichtung zum Verdampfen des in dem Behälter befindlichen Materials, wobei das zu beschichtende Material sich in einem Abstand von dem zu verdampfenden Material befindet, und mit einem Mikrowellensender, der Mikrowellen in den Raum zwischen dem zu verdampfenden Material und dem zu beschichtenden Material sendet.

Diese bekannte Anlage ermöglicht es, die Eigenschaften einer Metalloxid-Beschichtung auf einer Kunststoffolie zu verbessern.

Es ist auch eine Vorrichtung zum Aufstäuben eines dünnen Films bekannt, bei der die Geschwindigkeit des Niederbringens von Schichten unterschiedlicher Materialien regelbar ist (DE-A-39 12 572), um so zu extrem dünnen Schichtpaketen zu gelangen, wozu mindestens zwei unterschiedliche Arten von kathodenseitig vorgesehenen Gegenelektroden angeordnet sind.

Weiterhin ist eine Anordnung zum Abscheiden einer Metalllegierung mit Hilfe von HF-Kathodenzerstäubung bekannt (DE-A-35 41 621), bei der abwechselnd zwei Targets angesteuert werden, wobei die Targets die Metallkomponenten der abzuscheidenden Metallegierung jedoch mit unterschiedlichen Anteilen enthalten. Die Substrate sind zu diesem Zweck auf einem Substratträger angeordnet, der von einer Antriebseinheit während des Zerstäubungsvorgangs in Rotation versetzt wird.

Es ist außerdem bekannt (DE-A-38 02 852), bei einer Einrichtung für die Beschichtung eines Substrats mit zwei Elektroden und wenigstens einem zu zerstäubenden Material das zu beschichtende Substrat zwischen den beiden Elektroden in einem räumlichen Abstand anzuordnen und die Wechselstrom-Halbwellen als niederfrequente Halbwellen mit im wesentlichen gleichen Amplituden zu wählen.

Weiterhin ist eine Vorrichtung zum Beschichten eines Substrats, insbesondere mit nichtleitenden Schichten von elektrisch leitfähigen Targets in reaktiver Atmosphäre vorgeschlagen worden (DE-A-42 04 999), bestehend aus einer Stromquelle, die mit in einer evakuierbaren Beschichtungskammer angeordneten, Magnete einschließenden Kathoden verbunden ist, die elektrisch mit den Targets zusammenwirken, wobei zwei elektrisch voneinander und von der Sputterkammer getrennte Anoden angeordnet sind, die in einer Ebene zwischen den Kathoden und dem Substrat vorgesehen sind, wobei die beiden Ausgänge der Sekundärwicklung eines mit einem Mittelfrequenzgenerator verbundenen Transformators jeweils an eine Kathode über Versorgungsleitungen angeschlossen sind, wobei die erste und die zweite Versorgungsleitung über eine Zweigleitung untereinander verbunden sind, in die ein Schwingkreis, vorzugsweise eine Spule und ein Kondensator, eingeschaltet sind, und wobei jede der beiden Versorgungsleitungen jeweils sowohl über ein das Gleichspannungspotential gegenüber Erde einstellendes erstes elektrisches Glied mit der Beschichtungskammer als auch über ein entsprechendes zweites elektrisches Glied mit der jeweiligen Anode und über jeweils eine Zweigleitung mit eingeschaltetem Kondensator mit der Beschichtungskammer verbunden ist und wobei eine Drosselspule in den den Schwingkreis mit dem zweiten Sekundäranschluß verbindenen Abschnitt der ersten Versorgungsleitung eingeschaltet ist.

Weiterhin ist ein Verfahren bekannt (DE-C-44 12 906) für die ionengestützte Vakuumbeschichtung, vorzugsweise für die Hochratenbeschichtung großflächiger, elektrisch leitfähiger oder elektrisch isolierender Substrate mit elektrisch isolierenden Schichten und elektrisch isolierender Substrate mit elektrisch leitenden Schichten, indem zwischen einer Beschichtungsquelle und dem Substrat ein Plasma erzeugt wird, aus welchem Ionen in Richtung auf das Substrat beschleunigt werden, wobei an das elektrisch leitfähige Substrat oder an eine unmittelbar hinter dem elektrisch isolierenden Substrat angeordnete, sich über die gesamte Beschichtungsfläche erstreckende Elektrode abwechselnd negative und positive Spannungsimpulse relativ zum Plasma angelegt werden, daß die Dauer der negativen Impulse der Aufladezeit des sich über die isolierende Schicht und/oder das isolierende Substrat ausbildenden Kondensators angepaßt wird, daß die Dauer der positiven Impulse höchstens gleich, vorzugsweise 2- bis 10-mal kleiner als die Dauer der negativen Impulse gewählt wird, daß die positiven und negativen Impulse unmittelbar aneinander anschließen und annähernd auf die gleiche Höhe relativ zum Basispotential eingestellt werden, und daß die Höhe der Impulse relativ zum Basispotential ± 20 bis ± 2000 V, vorzugweise ± 50 bis ± 500 V, eingestellt wird.

Bekannt ist außerdem ein Verfahren und Einrichtung zum plasmaaktivierten Bedampfen, vorzugsweise zur reaktiven Beschichtung von Substraten im Vakuum durch Verdampfen eines direkt oder indirekt erhitzten Verdampfungsmaterials (DE-C-43 43 042), bei dem der sich ausbreitende Dampf zunächst teilweise von einem Plasma, welches von mindestens zwei Elektroden, die zeitlich wechselweise durch dieses Plasma abgestäubt werden, aufrechterhalten wird, durchdrungen und zur Wechselwirkung gebracht wird, wobei die Elektroden aus dem Verdampfungsmaterial oder einer Komponente des Verdampfungsmaterials und/oder einem Dotierungsmaterial, das der aufzubringenden Schicht hinzugefügt werden soll, verwendet werden, und das Plasma allein im Dampf des Verdampfungsmaterials und gegebenenfalls im reaktiven Gas und/oder einem inerten Gas aufrechterhalten wird.

Schließlich ist eine Vakuumbeschichtungsanlage bekannt mit einem in einer Vakuumkammer angeordneten Tiegel zur Aufnahme des zu verdampfenden Materials und mit einer das Material verdampfenden Quelle und mit einer in einem Abstand vom zu verdampfenden Material über Walzen geführten Folienbahn, wobei in dem Beschichtungsraum eine Ionenquelle vorgesehen ist (EP-A-0 570 618).

Transparente Kunststoffolien werden im verstärkten Maße für die Verpackung von Lebensmitteln eingesetzt. In erster Linie kommen hierbei Folien aus Polymer-Kunststoffen in Frage, die zwar flexibel sind, aber den Nachteil aufweisen, für Aromastoffe, Wasser oder Sauerstoff durchlässig zu sein. Wenn eine Diffusion solcher Stoffe ausgeschlossen werden soll, werden deshalb im allgemeinen Aluminiumfolien oder Kunststoffolien mit aufgedampftem Aluminium verwendet. Diese haben jedoch den Nachteil, daß sie relativ schwer zu entsorgen und für Mikrowellen und Licht nicht durchlässig sind. Durch die Verbreitung von Mikrowellenherden in vielen Haushalten der industrialisierten Länder ist die Mikrowellendurchlässigkeit des Verpakkungsmaterials in vielen Fällen von Bedeutung.

Um die Vorteile der Kunststoffolien, die für die Mikrowellen durchlässig sind, mit den Vorteilen der Aluminiumfolien, die eine absolute Sperre für Aromastoffe, Wasser und Sauerstoff bilden, zu vereinigen, ist es bereits bekannt, Polymer-Folien mit Metalloxiden zu beschichten. Hierbei spielt Siliziumoxid als Beschichtungsmaterial eine besondere Rolle. Die mit Siliziumoxid beschichteten Kunststoffolien haben bezüglich der Laminatstruktur und dem Barriereverhalten gegenüber Sauerstoff, Wasserdampf und Aroma ähnliche Eigenschaften wie Aluminiumfolie oder mit Aluminium beschichtete Kunststoffolien.

Die Beschichtung von Kunststoffolien mit Metalloxiden wie SiOₓ erfordert jedoch eine Prozeßtechnik, die sich stark von den üblichen Beschichtungstechniken unterscheidet, weil Metalloxide im Gegensatz zu Metallen aus der festen Phase heraus verdampft werden müssen.

Die Herstellung von SiOₓ-Schichten erfolgt durch das Verdampfen von SiO mittels eines Verdampfungsofens oder mittels Elektronenstrahl-Verdampfung (vgl. T. Krug, K. Rübsam: Die neue "gläserne Lebensmittelverpackung" in "neue Verpackung", Hüthig-Verlag, 1991) . SiOₓ-Schichten haben den Vorteil, daß sie leicht biegbar sind. Außerdem ist SiOₓ chemisch inert und korrosionsbeständig gegen Wasser. SiO kann ebenso wie Mgo, Al₂O₃ oder SiO₂ mit Hilfe eines Elektronenstrahls verdampft werden, da es einen relativ hohen Dampfdruck hat.

Der vorliegenden Erfindung liegt die Aufgabe zugrunde, eine Vakuumbeschichtungsanlage zu schaffen, die eine Beschichtung von Folien, insbesondere Verpackungsfolien, mit transparenten Barriereschichten mit hoher Rate und Qualität ermöglicht. Die Anlage soll trotz der sich abscheidenden parasitären oxydischen Schichten eine hohe Standzeit aufweisen und eine hohe Prozeßstabilität ermöglichen.

Gemäß der Erfindung wird diese Aufgabe gelöst durch eine in einem Abstand vom zu verdampfenden Material gehaltene über Walzen geführte Folienbahn, wobei beiderseits der die Folienbahn am Tiegel vorbeiführenden Beschichtungswalze je eine Kammer angeordnet ist, in der jeweils eine mit einer Mittelfrequenzstromquelle verbundene Magnetronkathode vorgesehen ist, wobei jede der beiden Kammern über jeweils einen Kanal mit der Zone unmittelbar zwischen der Beschichtungswalze und dem Tiegel verbunden ist, wobei oberhalb dieser Kanäle eine Trennwand vorgesehen ist, die den Beschichtungsraum vom Wickelraum trennt, und wobei beide Kammern jeweils über Druckmittelleitungen an Quellen für ein Prozeßgas angeschlossen sind.

Weitere Einzelheiten und Merkmale sind in den Patentansprüchen näher beschrieben und gekennzeichnet.

Die Erfindung läßt die verschiedensten Ausführungsmöglichkeiten zu; drei davon sind in den anhängenden Zeichnungen rein schematisch näher dargestellt, die Vakuumbeschichtungsanlagen im Schnitt zeigen.

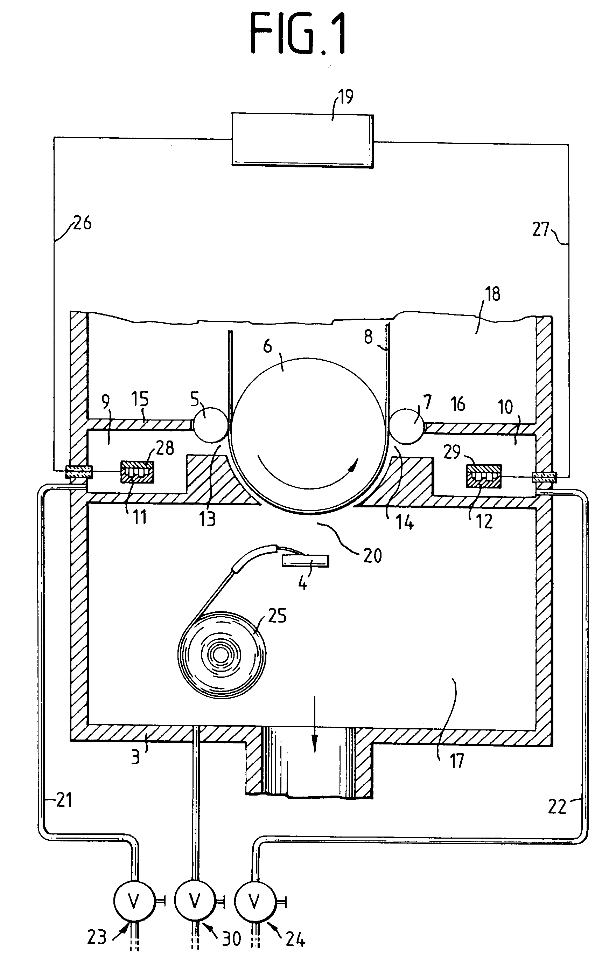

In Figur 1 ist eine Vakuumkammer 3 dargestellt, in welcher ein länglicher Tiegel 4 angeordnet ist. Oberhalb dieses Tiegels 4 ist eine Beschichtungswalze 6 vorgesehen, welche eine Beschichtungskammer 17 nach oben hin begrenzt. Über diese Beschichtungswalze 6 läuft kontinuierlich eine zu beschichtende Folie 8, welche von einer Vorratsrolle abgewickelt und auf eine Aufwickelrolle aufgewickelt wird.

Zum Beheizen des Tiegels 4 dient ein Widerstandsheizelement, wobei das Nachchargieren des zu verdampfenden Materials in Drahtform von einer motorisch angetriebenen Vorratsrolle 25 aus geschieht. Beiderseits der Beschichtungswalze 6 drücken Walzen 5,7 die Folienbahn 8 an diese Beschichtungswalze 6 an und sorgen gleichzeitig für eine gute Abdichtung gegenüber den Trennwänden 15,16 , die den eigentlichen Beschichtungsraum 17 von der Wickelkammer 18 trennt. Beiderseits der Beschichtungswalze 6 sind außerdem Kammern 9,10 vorgesehen, in denen Sputterkathoden 11,12 angeordnet sind. Die Sputterkathoden 11,12 sind jeweils über Versorgungsleitungen 26,27 an eine Mittelfrequenz-Stromversorgung 19 angeschlossen. Die Kammern 9,10 stehen jeweils über Versorgungsleitungen 21,22 mit den Plasmaquellen 23,24 in Verbindung und sind im übrigen über Kanäle 13,14 mit der Zone 20 unmittelbar unterhalb der Beschichtungswalze 6 und oberhalb der Verdampferquelle bzw. des Tiegels 4 verbunden.

Die Sputterkathoden 11,12 sind als Magnetrons ausgebildet und so bemessen, daß ihre längste Ausdehnung mindestens so lang wie die Länge der als Kühlwalzen ausgebildeten Walzen 5,6,7 ist, wobei sich ihre Längsachsen parallel der Walzenachsen erstrecken. Die Targets 28,29 der beiden Kathoden 11,12 sind jeweils auf die Trennwand 15 bzw. 16 ausgerichtet.

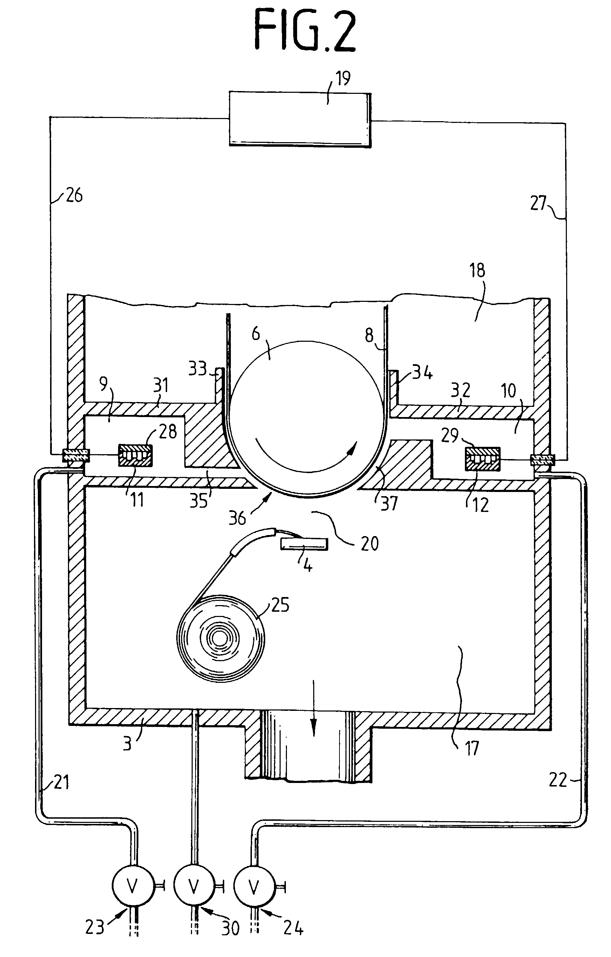

Die Ausführungsform gemäß Figur 2 unterscheidet sich von derjenigen nach Figur 1 dadurch, daß an der Beschichtungswalze 6 nicht zwei Walzen anliegen und die Abdichtung des Beschichtungsraums 17 gegenüber der Wickelkammer 18 übernehmen, sondern daß die Trennwände 31,32 mit sehr eng an der Beschichtungswalze 6 anliegenden Drahtleisten 33,34 versehen sind. Darüber hinaus ist die Kammer 9 über einen Kanal oder Spalt 35 mit der Zone 20 verbunden, der sehr nahe an dem Abschnitt der Beschichtungswalze 6 einmündet, der dem Tiegel 4 zugekehrt ist und das eigentliche Beschichtungsfenster 36 bildet. Auch die zweite Kammer 10 für die Kathode 12 ist über einen Spalt oder Kanal 37 mit der Zone 20 verbunden, wobei dieser allerdings länger bemessen ist als der, der auf der anderen Seite der Beschichtungswalze 6 angeordnet ist.

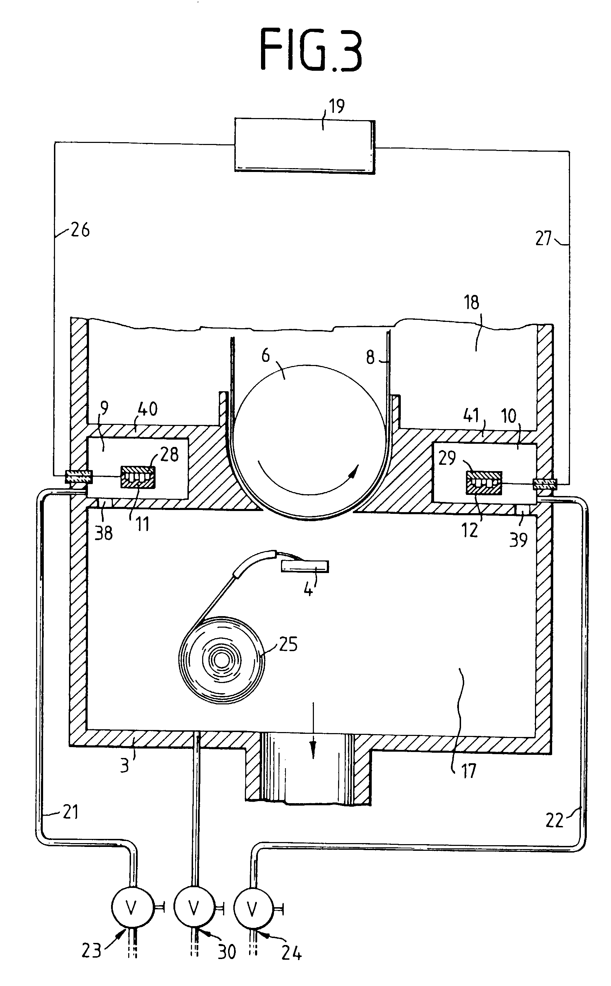

Beim Ausführungsbeispiel gemäß Figur 3 sind die beiden beiderseits der Beschichtungswalze 6 vorgesehenen Kammern 9,10 über Öffnungen 38,39 direkt mit der Vakuumkammer verbunden, wobei die Beschichtungswalze 6 gegenüber den Trennwänden 40,41 ausschließlich über die schmalen Spalte zwischen der Folienbahn 8 und den der Walze 6 angepaßten Seitenabschnitten der Trennwände 40,41 erfolgt.

Werden die Spalte oder Kanäle 13,14 wie in Figur 1 angeordnet, so daß die Spalte zwischen Walzenabdeckung und Kühlwalze bzw. Beschichtungswalze 6 liegen, so breitet sich das Plasma entlang der auf der Walze liegenden Folie 8 aus. Durch andere konstruktive Aufteilung kann der Umschlingungswinkel gegenüber den in Figur 1 dargestellten 180° leicht vergrößert werden. Umschlingungswinkel bis zu 270° sind problemlos. In Figur 2 wird nur eine kurze Vorbehandlung erwünscht. Deshalb ist der Kanal 35 auf der Abwickelseite verkürzt worden. Figur 3 zeigt, daß die Kanäle 38,39 auch außerhalb der Kühlwalze 6 liegen können, um nur eine schwache Ioneneinwirkung und nur in der Beschichtungszone zu erhalten. Die beiden Magnetrons 11,12 sind mit einer Wechselspannungsquelle 19 verbunden. Die Wechselspannung kann z.B. 40 kHz betragen, das Verfahren arbeitet jedoch auch mit tieferen Frequenzen.

Die beiden Magnetrons 11,12 tragen Targets, deren abgestäubte Teilchen im Falle der Figur 2 die Folie 8 nicht erreichen sollen. Es ist aber auch möglich, ein oder beide Targets 28,29 in Richtung der Kühlwalze 6 zu orientieren, so daß die Magnetrons auf die Folie 8 stäuben, wenn man z.B. für die ersten Lagen der Schicht die bessere Haftfestigkeit der aufgestäubten gegenüber der aufgedampften Schicht ausnutzen will.

Die Gasversorgung mit den Reaktivgasen (O₂, N₂, organische Verbindungen ... ) ist für die einzelnen Kammern 9,10 getrennt dargestellt, um die Möglichkeit zu erhalten, die optimalen Bedingungen für jeden Prozeß einstellen zu können, und um die verschiedenen Kammern mit gleichen oder verschiedenen Gasen bzw. Gemischen speisen zu können.

Gegenüber Vorrichtungen ohne Wechselspannung betriebene Magnetrons besteht der Vorteil der hohen Plasmadichte, die ein intensives Bombardement während des Schichtwachstums gestattet. Gegenüber der vorbekannten Lösung gemäß DE-C-44 12 906 ergibt sich der Vorteil, daß die beiden Magnetrons 11,12 in getrennten Abteilungen der Vakuumkammer angebracht sind und so nicht durch parasitär aufwachsende Schichten belegt werden können. Die Anordnung erzwingt ein Plasmaband über einen großen Umschlingungswinkel der Beschichtungswalze. Dadurch wird gegenüber der bekannten Lösung ein wesentlich längerer und intensiverer Plasmakontakt erzielt, der für den gewünschten Schichtaufbau wesentlich ist. Die Länge der Einwirkzone des Plasmas ist nicht vorgegeben. Durch konstruktive Gestaltung ist es möglich, die Länge der Einwirkzone unabhängig von der Beschichtungszone festzulegen, z.B. ohne Vorbehandlung oder mit kurzer Vorbehandlung. Durch die Abtrennung ist es ferner möglich, evtl. unter Verwendung zusätzlicher Vakuumpumpen und die Steuerung der Gaseinlässe für die Reaktivgase, sowohl den Verdampfer als auch die Magnetrons in den jeweils optimalen Druckbereichen zu betreiben. Damit ist es möglich, die Erzeugung von Radikalen aus den Reaktivgasen unabhängig vom Aufdampfprozeß zu steuern. Bei dem Einsatz von Elektronenverdampfungsquellen tritt das Problem auf, daß die nichtleitende Schicht oder die Folie stark aufgeladen wird, was zu Problemen beim Wickeln führt. Da das Plasma quasineutral ist, werden Ladungsträger aus dem Plasma auf die Folie gezogen und damit die Ladungen abgebaut, wenn die Folie die in Aufwickelrichtung liegende Magnetron-Abteilung passiert.

### Bezugszeichenliste

- 2 3: Vakuumkammer
- 4: Tiegel
- 5: Walze
- 6: Beschichtungswalze
- 7: Walze
- 8: Folienbahn
- 9: Kammer
- 10: Kammer
- 11: Magnetronkathode
- 12: Magnetronkathode
- 13: Kanal
- 14: Kanal
- 15: Trennwand
- 16: Trennwand
- 17: Beschichtungsraum
- 18: Wickelkammer
- 19: Mittelfrequenzquelle
- 20: Beschichtungszone
- 21: Druckmittelleitung
- 22: Druckmittelleitung
- 23: Prozeßgasquelle
- 24: Prozeßgasquelle
- 25: Vorratsrolle
- 26: El. Versorgungsleitung
- 27: El. Versorgungsleitung
- 28: Target
- 29: Target
- 30: Prozeßgasquelle
- 31: Trennwand
- 32: Trennwand
- 33: Dichtleiste
- 34: Dichtleiste
- 35: Kanal
- 36: Beschichtungsfenster
- 37: Kanal, Spalt
- 38: Öffnung , Kanal
- 39: Öffnung, Kanal
- 40: Trennwand
- 41: Trennwand

## Patentansprüche

1. Vakuumbeschichtungsanlage mit einem in einer Vakuumkammer (3) angeordneten Tiegel (4) zur Aufnahme des zu verdampfenden Materials, beispielsweise eines Metalls oder Metalloxids oder einer Mischung eines Metalls mit einem Metalloxid und einer das Material verdampfenden Quelle und mit einer in einem Abstand vom zu verdampfenden Material gehaltenen über Walzen (5,6,7) geführten Folienbahn (8), wobei beiderseits der die Folienbahn (8) am Tiegel (4) vorbeiführenden Beschichtungswalze (6) je eine Kammer (9,10) angeordnet ist, in der jeweils eine mit einer Mittelfrequenzquelle (19) verbundene Magnetronkathode (11 bzw. 12) vorgesehen ist, wobei jede der beiden Kammern (9,10) jeweils über einen Kanal (13,14,35,37,38,39) mit der Zone (20) unmittelbar zwischen mit der Beschichtungswalze (6) und dem Tiegel (4) verbunden ist, wobei oberhalb dieser Kanäle (13,14,35,37,38,39) eine Trennwand (15,16,31,32,40,41) vorgesehen ist, die den Beschichtungsraum (17) vom Wickelraum (18) trennt, und wobei beide Kammern (9,10) jeweils über Druckmittelleitungen (21,22) an Quellen (23,24) für ein Prozeßgas angeschlossen sind.

2. Vakuumbeschichtungsanlage nach Anspruch 1, **dadurch gekennzeichnet,** daß die Targets (28,29) der in den beiden Kammern (9,10) beiderseits der Beschichtungswalze (6) angeordneten Kathoden (11,12) auf die Trennwand (15,16 bzw. 31,32 bzw. 40,41) ausgerichtet sind.

3. Vakuumbeschichtungsanlage nach Anspruch 1, **dadurch gekennzeichnet,** daß beiderseits der Beschichtungswalze (6) weitere Walzen (5,7) drehbar an der die Vakuumkammer in zwei Kammern (17,18) teilenden Trennwand (15,16) gelagert sind, deren Rotationsachsen parallel der Rotationsachse der Beschichtungswalze (6) ausgerichtet sind und die einerseits die Folienbahn (8) an die Beschichtungswalze (6) andrücken und die andererseits die die Kammern (9,10) mit dem Beschichtungsraum (17) verbindenden Kanäle (13,14) gegenüber der Trennwand und damit gegenüber der Wickelkammer (18) abdichten.

4. Vakuumbeschichtungsanlage nach Anspruch 1, **dadurch gekennzeichnet,** daß die Kanäle (13,14 bzw. 35,37), die die Kathoden (11,12) aufnehmenden Kammern (9,10) beiderseits der Beschichtungswalze (6) mit dem die Verdampferquelle (4) enthaltenden Beschichtungsraum (17) verbinden, zumindest teilweise von der zylindrischen Mantelfläche der Beschichtungswalze (6) und der auf dieser aufliegenden Folienbahn (8) begrenzt sind.

5. Vakuumbeschichtungsanlage nach einem oder mehreren der vorhergehenden Ansprüche, **dadurch gekennzeichnet,** daß die Beschichtungswalze (6) von einem Kühlmittel durchflossen ist.

6. Vakuumbeschichtungsanlage nach Anspruch 1, **dadurch gekennzeichnet,** daß die beiderseits der Beschichtungswalze (6) angeordneten, die Kathoden (11,12) umschließenden Kammern (9,10) über Kanäle (38,39) mit dem Beschichtungsraum (17) verbunden sind, die in den Trennwänden zwischen den Kammern (9,10) und dem Beschichtungsraum vorgesehen sind.

## Claims

1. A vacuum coating apparatus comprising a crucible (4) arranged in a vacuum chamber (3) for the accommodation of the material to be vaporized, for example a metal or metal oxide or a mixture of a metal and a metal oxide, and a source which vaporizes the material, and comprising a film sheet (8) which is maintained at a distance from the material to be vaporized and is conducted across rollers (5, 6,7), wherein a chamber (9, 10) is in each case arranged on both sides of the coating roller (6) which conducts the film sheet (8) past the crucible (4), in which chamber a magnetron cathode (11, 12) connected to a medium frequency source (19) is in each case provided, wherein each of the two chambers (9, 10) is in each case connected via a channel (13, 14, 35, 37, 38, 39) to the zone (20) directly between the coating roller (6) and the crucible (4), wherein a partition wall (15, 16, 31, 32, 40, 41) separating the coating chamber (17) from the winding chamber (18) is provided above these channels (13, 14, 35, 37, 38, 39) and wherein the two chambers (9, 10) are in each case connected via pressure medium lines (21, 22) to sources (23, 24) for a process gas.

2. A vacuum coating apparatus according to Claim 1, characterised in that the targets (28, 29) of the cathodes (11, 12) arranged in the two chambers (9, 10) on both sides of the coating roller (6) are aligned with the partition wall (15, 16; 31, 32; 40, 41).

3. A vacuum coating apparatus according to Claim 1, characterised in that on both sides of the coating roller (6) further rollers (5, 7), whose rotation axes are aligned in parallel with the rotation axis of the coating roller (6), are rotatably mounted on the partition wall (15, 16) dividing the vacuum chamber into two chambers (17, 18), which further rollers (5, 7) on the one hand press the film sheet (8) against the coating roller (6) and on the other hand seal the channels (13, 14) connecting the chambers (9, 10) to the coating chamber (17) from the partition wall and thus from the winding chamber (18).

4. A vacuum coating apparatus according to Claim 1, characterised in that the channels (13, 14; 35, 37), by which the chambers (9, 10) accommodating the cathodes (11, 12) on both sides of the coating roller (6) are connected to the coating chamber (17) containing the vaporizer source (4), are at least partially delimited by the cylindrical side-wall surface of the coating roller (6) and the film sheet (8) arranged thereon.

5. A vacuum coating apparatus according to one or more of the preceding claims, characterised in that the coating roller (6) is traversed by a coolant.

6. A vacuum coating apparatus according to Claim 1, characterised in that the chambers (9, 10) arranged on both sides of the coating roller (6) and enclosing the cathodes (11, 12) are connected to the coating chamber (17) via channels (38, 39) provided in the partition walls between the chambers (9, 10) and the coating chamber.

## Revendications

1. Installation de revêtement sous vide comportant un creuset (4) agencé dans une chambre à vide (3) et destiné à recevoir le matériau à vaporiser, par exemple un métal, ou un oxyde métallique, ou un mélange d'un métal avec un oxyde métallique et avec une source vaporisant le matériau, et comportant une bande de film (8) guidée par l'intermédiaire de cylindres (5, 6, 7) à distance du matériau à vaporiser, dans laquelle une chambre respective (9, 10) est agencée des deux côtés du cylindre de revêtement (6) amenant la bande de film (8) le long du creuset (4), dans laquelle est prévue une cathode à magnétron respective (11 ou 12) reliée à une source à moyenne fréquence (19), dans laquelle chacune des deux chambres (9, 10) est reliée via un canal respectif (13, 14, 35, 37, 38, 39) à la zone (20) directement entre le cylindre de revêtement (6) et le creuset (4), dans laquelle au-dessus de ces canaux (13, 14, 35, 37, 38, 39) est prévue une paroi de séparation (15, 16, 31, 32, 40, 41) qui sépare la chambre de revêtement (17) de la chambre d'enroulement (18), et dans laquelle les deux chambres (9, 10) sont raccordées chacune via des conduites à fluide sous pression (21, 22) à des sources (23, 24) de gaz réactif.

2. Installation de revêtement sous vide selon la revendication 1, caractérisée en ce que les cibles (28, 29) des cathodes (11, 12) agencées dans les deux chambres (9, 10) des deux côtés du cylindre de revêtement (6) sont orientées vers la paroi de séparation (15, 16 ou 31, 32 ou 40, 41).

3. Installation de revêtement sous vide selon la revendication 1, caractérisée en ce que des deux côtés du cylindre de revêtement (6), d'autres cylindres (5, 7) sont montés en rotation sur la paroi de séparation (15, 16) qui divise la chambre à vide en deux chambres (17, 18), dont les axes de rotation sont dirigés parallèlement à l'axe de rotation du cylindre de revêtement (6), lesdits cylindres appuyant d'une part la bande de film (8) contre le cylindre de revêtement (6) et étanchant d'autre part les canaux (13, 14) reliant les chambres (9, 10) à la chambre de revêtement (17) par rapport à la paroi de séparation et ainsi par rapport à la chambre d'enroulement (18).

4. Installation de revêtement sous vide selon la revendication 1, caractérisée en ce que les canaux (13, 14 ou 35, 37), qui relient les chambres (9, 10) recevant les cathodes (11, 12) des deux côtés du cylindre de revêtement (6) à la chambre de revêtement (17) contenant la source de vaporisation (4), sont limités du moins en partie par la surface enveloppe cylindrique du cylindre de revêtement (6) et par la bande de film (8) reposant sur celui-ci.

5. Installation de revêtement sous vide selon l'une ou plusieurs des revendications précédentes, caractérisée en ce que le cylindre de revêtement (6) est traversé par un agent de refroidissement.

6. Installation de revêtement sous vide selon la revendication 1, caractérisée en ce que les chambres (9, 10) agencées des deux côtés du cylindre de revêtement (6) et entourant les cathodes (11, 12) sont reliées à la chambre de revêtement (17) via des canaux (38, 39) qui sont prévus dans les parois de séparation entre les chambres (9, 10) et la chambre de revêtement.
